# DEMANDE DE BREVET EUROPEEN

(11) **EP 4 760 316 A1**
(43) Date de publication de la demande: **17.06.2026**
(21) Numéro de dépôt: 25219966.6
(22) Date de dépôt: 02.12.2025
(51) Int. Cl.: G01R 31/396, H02J 7/00, H02J 7/80, H02J 7/84, G01R 31/367

(54) **PROCEDE D'OPTIMISATION DE LA DUREE DE VIE D'UNE BATTERIE DE STOCKAGE ELECTRIQUE**

(30) Priorité: 13.12.2024 FR 2414098
(71) Demandeur: Commissariat à l'Energie Atomique et aux Energies Alternatives, 75015 Paris (FR); Schaeffler Technologies AG & Co. KG, 91074 Herzogenaurach (DE)
(72) Inventeur: BLATTER, Jérôme, 38054 Grenoble cedex 09 (FR); LETO, Nicolas, 31100 TOULOUSE (FR); THOMAS, Rémy, 38054 Grenoble cedex 09 (FR); HEIRIES, Vincent, 38054 Grenoble cedex 09 (FR); LACHAIZE, Jérôme, 31100 TOULOUSE (FR)
(74) Mandataire: INNOV-GROUP

(57) **Abrégé**

L'invention concerne un procédé d'optimisation de la durée de vie d'une batterie de stockage électrique (6), mis en œuvre dans un calculateur (4) comprenant des moyens mémoire (8) stockant un modèle (12) de vieillissement de la batterie de stockage électrique (6), la batterie de stockage électrique (6) étant une batterie à équilibrage actif avec transfert de puissance ou une batterie reconfigurable et comprenant une pluralité d'accumulateurs électrochimiques ou de modules d'accumulateurs électrochimiques connectés en série et/ou en parallèle, le calculateur (4) comprenant en outre un contrôleur (10) configuré pour commander l'état de charge électrique de chaque accumulateur électrochimique ou de chaque module d'accumulateurs électrochimiques de la batterie (6). L'invention concerne également un produit programme d'ordinateur pour la mise en œuvre d'un tel procédé, ainsi qu'un véhicule automobile (2) comprenant un calculateur (4) stockant un tel produit programme d'ordinateur.

## Description

La présente invention concerne l'optimisation de la durée de vie d'une batterie de stockage électrique. La batterie de stockage électrique est typiquement une batterie de traction d'un véhicule automobile électrique ou hybride, sans que cela ne soit limitatif dans le cadre de la présente invention. La batterie de stockage électrique peut également être, selon d'autres applications envisagées pour l'invention, une batterie stationnaire ou encore une batterie de stockage électrique d'un véhicule électrique non automobile tel que par exemple un poids lourd, un bateau ou encore un avion.

Un véhicule automobile électrique ou hybride est classiquement muni d'au moins une batterie de stockage électrique utilisée dans la chaîne de traction du véhicule. Une telle batterie est appelée « batterie de traction ». Une telle batterie de traction est généralement composée de plusieurs accumulateurs électrochimiques connectés en série et/ou en parallèle pour augmenter la tension électrique, le courant électrique, la capacité électrique, l'énergie électrique et/ou la puissance électrique de la batterie. En outre, lorsque la batterie est composée d'au moins quelques dizaines d'accumulateurs électrochimiques, les constructeurs de batterie choisissent souvent d'assembler dans un premier temps des modules composés d'accumulateurs en série et en parallèle pour assembler ensuite la batterie à partir de ces différents modules connectés en série et/ou en parallèle.

Aujourd'hui, la plupart des grandes batteries électriques sont construites avec une configuration fixe d'accumulateurs électrochimiques identiques en série et/ou en parallèle. Ainsi, un état équilibré entre les accumulateurs est privilégié pour que, pendant l'utilisation de la batterie, l'ensemble des accumulateurs atteignent en même temps l'état complètement chargé et déchargé pour maximiser l'utilisation de l'énergie embarquée (énergie utile stockable). Cependant, pendant la durée de vie de la batterie, des conditions légèrement différentes entre accumulateurs peuvent faire apparaître une dispersion entre accumulateurs, qui les empêche d'atteindre en même temps l'état complètement chargé et déchargé. Il est ainsi connu des méthodes d'équilibrage d'accumulateurs, qui sont utilisées afin de compenser cette dispersion.

Parmi de telles méthodes d'équilibrage, on peut notamment citer les deux méthodes suivantes :
- l'équilibrage passif qui consiste à surcharger les accumulateurs avec les plus hauts états de charge jusqu'à ce que l'ensemble des accumulateurs soient pleinement chargés. En effet, l'énergie supplémentaire est dissipée sous forme de perte joule ou sous forme de réaction chimique secondaire dans l'accumulateur ; et
- l'équilibrage dissipatif qui consiste à dissiper de l'énergie des accumulateurs les plus chargés par des pertes Joule dans des composants d'électronique de puissance, jusqu'à ce que l'ensemble des accumulateurs soient chargés. Il s'agit notamment de la méthode la plus utilisée pour les batteries lithium-ion parce que les réactions chimiques secondaires apparaissant pendant la surcharge de l'équilibrage passif sont destructives pour les accumulateurs lithium-ion.

Toutefois, ni les méthodes d'équilibrage passif ni les méthodes d'équilibrage dissipatif ne permettent d'atteindre en même temps l'état complètement déchargé de l'ensemble des accumulateurs. Ainsi, des méthodes et des batteries plus complexes sont utilisées pour atteindre cet objectif. C'est le cas notamment des deux technologies d'équilibrage suivantes :
- l'équilibrage actif avec transfert de puissance ou d'énergie entre accumulateurs, qui consiste à utiliser des composants d'électronique de puissance et de stockage d'énergie tel que des condensateurs et des inductances ; et
- les batteries reconfigurables qui utilisent de l'électronique de puissance pour changer en temps réel la configuration en série ou en parallèle des accumulateurs ou des modules. On peut également ajouter dans cette dernière catégorie les batteries ayant des convertisseurs de puissance au niveau de chaque module.

Par la suite, on entend par « batteries à équilibrage actif » au sens de la présente invention à la fois les batteries mettant en œuvre une méthode d'équilibrage avec transfert de puissance, et les batteries reconfigurables. Avec de telles batteries à équilibrage actif, il est possible d'atteindre en même temps l'état complètement chargé et l'état complètement déchargé de l'ensemble des accumulateurs dans la batterie, ce qui permet de stocker plus d'énergie utile.

Il est connu de l'art antérieur des solutions d'optimisation de la durée de vie d'une batterie à équilibrage actif d'un véhicule, permettant une réduction de la perte de capacité de la batterie avec un meilleur équilibrage en température et sur les états de charge des accumulateurs de la batterie. Par « état de charge » on entend au sens de la présente invention un pourcentage qui évolue de 100 % à 0 % et qui permet de caractériser la capacité électrique restante d'une batterie électrique par rapport à sa capacité électrique totale. Un état de charge de 100 % indique une batterie entièrement chargée, tandis que 0 % indique une batterie entièrement déchargée. Les critères de 100% chargée et 0% chargée sont définis par les constructeurs et varient en fonction de la chimie des accumulateurs électrochimiques de la batterie.

La demande de brevets FR3118310A1 décrit un procédé pour estimer la durée de vie d'un système de stockage d'énergie électrique.

La demande de brevet US2022/268842A1 décrit un système de gestion de batterie utilisant deux voies de détermination de la batterie en redondance.

La demande de brevet EP3974853A1 décrit une solution de prédiction de l'état de santé d'une batterie.

En particulier, certaines solutions connues permettent une minimisation de la perte de capacité électrique de la batterie avec des stratégies de contrôle optimal sur un modèle de batterie qui contient un modèle de vieillissement. Un tel modèle de vieillissement incorpore généralement une fonction représentant une perte de capacité de la batterie de stockage électrique en fonction de l'état d'énergie de la batterie. Par « état d'énergie » on entend au sens de la présente invention un pourcentage qui évolue de 100 % à 0 % et qui permet de caractériser une mesure de l'énergie restante dans un accumulateur électrochimique par rapport à l'énergie totale que l'on pourrait tirer de cet accumulateur si on le déchargeait complètement. L'énergie totale est calculable en intégrant la puissance de l'accumulateur sur une décharge complète. Un état d'énergie de 100 % indique une batterie entièrement chargée, tandis que 0 % indique une batterie entièrement déchargée. L'état d'énergie d'un accumulateur électrochimique peut aussi être défini comme étant l'état d'énergie de l'accumulateur avec la tension de ce dernier équivalente à la tension de circuit ouvert avec un état de santé égal à 100 % et une température égale à 25°C.

Les résultats du contrôle optimal montrent qu'un contrôle favorisant l'utilisation d'un groupe d'accumulateurs particulier apporte une réduction de vieillissement significative. Toutefois, un inconvénient de ces solutions connues est qu'elles ne cherchent à optimiser la durée de vie de la batterie à équilibrage actif que lors du cyclage de la batterie, et ne tiennent par conséquent pas compte du temps de stationnement du véhicule. Or, le temps de parking des véhicules électriques ou hybrides joue un rôle important dans la perte de capacité de la batterie de traction de tels véhicules.

Il existe donc un besoin de pouvoir disposer d'un procédé d'optimisation de la durée de vie d'une batterie à équilibrage actif, tenant compte du temps d'inutilisation de la batterie et permettant d'augmenter la durée de vie de la batterie, et ce pour tout type de chimie relative aux accumulateurs électrochimiques de la batterie.

A cette fin, l'invention concerne un procédé, mis en œuvre dans un calculateur, d'optimisation de la durée de vie d'une batterie de stockage électrique, le calculateur étant relié à la batterie de stockage électrique, le calculateur comprenant des moyens mémoire stockant un modèle de vieillissement de la batterie de stockage électrique, ledit modèle de vieillissement incorporant une fonction représentant une perte de capacité de la batterie de stockage électrique en fonction de l'état d'énergie de la batterie, la batterie de stockage électrique étant une batterie à équilibrage actif avec transfert de puissance ou une batterie reconfigurable et comprenant une pluralité d'accumulateurs électrochimiques ou de modules d'accumulateurs électrochimiques connectés en série et/ou en parallèle, le calculateur comprenant en outre un contrôleur configuré pour commander **l'état de** charge électrique de chaque accumulateur électrochimique ou de chaque module d'accumulateurs électrochimiques de la batterie, les états de charge électrique des accumulateurs électrochimiques ou des modules d'accumulateurs électrochimiques respectant au moins une contrainte d'utilisation, ledit procédé étant mis en œuvre pendant une durée divisée en instants d'échantillonnage constants, chaque instant d'échantillonnage correspondant à un état d'énergie de la batterie, le procédé comprenant les étapes de :
- détermination initiale de si la fonction représentant la perte de capacité de la batterie de stockage électrique en fonction de l'état d'énergie de la batterie présente ou non une convexité globale stricte ou une concavité globale stricte ;
- si ladite fonction présente une convexité globale stricte, mise en œuvre, à chaque instant d'échantillonnage, d'une commande d'équilibrage des états de charge électrique des accumulateurs électrochimiques ou des modules d'accumulateurs électrochimiques ;
- si ladite fonction présente une concavité globale stricte, mise en œuvre, à chaque instant d'échantillonnage, d'une commande de déséquilibrage des états de charge électrique des accumulateurs électrochimiques ou des modules d'accumulateurs électrochimiques ;
- si ladite fonction ne présente ni de convexité globale stricte ni de concavité globale stricte, mise en œuvre, à chaque instant d'échantillonnage, des étapes suivantes :
   ∘ détermination de si la fonction représentant la perte de capacité de la batterie de stockage électrique en fonction de l'état d'énergie de la batterie présente une convexité ou une concavité locale stricte autour de l'état d'énergie courant de la batterie ;
   ∘ si ladite fonction présente une concavité locale stricte autour de l'état d'énergie courant de la batterie, mise en œuvre d'une commande de déséquilibrage des états de charge électrique des accumulateurs électrochimiques ou des modules d'accumulateurs électrochimiques ;
   ∘ si ladite fonction présente une convexité locale stricte autour de l'état d'énergie courant de la batterie, détermination de si une commande d'équilibrage des états de charge électrique des accumulateurs électrochimiques ou des modules d'accumulateurs électrochimiques correspond à un minimum global de ladite fonction ;
      - si une commande d'équilibrage des états de charge électrique des accumulateurs électrochimiques ou des modules d'accumulateurs électrochimiques correspond à un minimum global de ladite fonction, mise en œuvre d'une commande d'équilibrage des états de charge électrique des accumulateurs électrochimiques ou des modules d'accumulateurs électrochimiques ;
      - si une commande d'équilibrage des états de charge électrique des accumulateurs électrochimiques ou des modules d'accumulateurs électrochimiques ne correspond pas à un minimum global de ladite fonction, mise en œuvre d'une commande de déséquilibrage des états de charge électrique des accumulateurs électrochimiques ou des modules d'accumulateurs électrochimiques.

Le procédé d'optimisation selon l'invention tire parti de ce qu'un état équilibré entre accumulateurs ou modules est recherché lorsque la batterie s'approche de l'état complètement chargé ou de l'état complètement déchargé, ceci afin de maximiser l'énergie utile stockable. Or, pour une batterie à équilibrage actif (comme c'est le cas dans le procédé selon l'invention), un état équilibré n'est pas forcément nécessaire dans un état de charge intermédiaire de la batterie, ce qui donne un degré de liberté supplémentaire à une telle batterie. En effet, les batteries de stockage électrique ont une forte probabilité d'être utilisées dans une plage d'état de charge élevée à cause de ce qui est appelé « l'anxiété de l'autonomie de l'utilisateur » et du fait qu'elles ne sont pas souvent chargées à 100 % d'état de charge à cause d'une restriction du constructeur ou de conseils d'utilisation du constructeur.

Le principe de la présente l'invention consiste alors à utiliser ce degré de liberté supplémentaire de la batterie entre l'état complément chargé et déchargé de cette dernière, ceci afin d'augmenter significativement la durée de vie de la batterie. Ceci est réalisé en prenant en compte des états spécifiques pour lesquels un déséquilibrage des états de charge des accumulateurs de la batterie est optimal (i.e. lorsque la fonction matérialisant le vieillissement de la batterie présente une concavité locale ou globale stricte, ou si la commande d'équilibrage ne correspond pas à un minimum global de la fonction) et d'autres états pour lesquels, au contraire, un équilibrage des états de charge des accumulateurs de la batterie est optimal (i.e. lorsque la fonction matérialisant le vieillissement de la batterie présente une convexité globale stricte, ou une convexité locale stricte et que la commande d'équilibrage correspond à un minimum global de la fonction). Ceci permet ainsi un pilotage plus fin et plus précis de l'état de charge des accumulateurs, comparativement aux stratégies de contrôle optimal de l'art antérieur qui visent à l'utilisation d'un groupe d'accumulateurs particulier, ce qui permet d'augmenter substantiellement la durée de vie de la batterie et ce indépendamment de la chimie relative aux accumulateurs. En outre, un tel procédé d'optimisation prend en compte le temps d'inutilisation de la batterie, ce qui est avantageux du point de vue de la précision du contrôle.

Selon un mode de réalisation préféré, le calculateur est embarqué au sein d'un véhicule automobile électrique ou hybride, et la batterie de stockage électrique est une batterie de ce véhicule. Selon ce mode de réalisation préféré, le temps d'inutilisation de la batterie correspond à un temps de stationnement du véhicule automobile.

Selon une variante, le calculateur comprend en outre un module d'estimation connecté entre une sortie de la batterie de stockage électrique et une entrée du contrôleur, le module d'estimation étant configuré pour recevoir au moins une mesure d'un paramètre physique relatif à la batterie et pour estimer, en fonction de ladite au moins une mesure, au moins un paramètre relatif à l'état de la batterie, et chaque commande d'équilibrage ou de déséquilibrage des états de charge électrique des accumulateurs électrochimiques ou des modules d'accumulateurs électrochimiques est réalisée en tenant compte dudit au moins un paramètre relatif à l'état de la batterie. Ceci permet de prendre en compte, en entrée du contrôleur, le ou les état(s) de charge, d'énergie ou de santé de la batterie, et d'améliorer ainsi encore la précision du contrôle.

Selon une variante, le module d'estimation est configuré en outre pour mettre à jour la fonction représentant la perte de capacité de la batterie de stockage électrique en fonction de l'état d'énergie de la batterie, en fonction dudit au moins un paramètre relatif à l'état de la batterie, chaque instant d'échantillonnage correspondant en outre à un instant pour lequel ladite fonction représentant la perte de capacité de la batterie de stockage électrique en fonction de l'état d'énergie de la batterie est mise à jour. Ceci permet de prendre en compte en quasi temps réel, en entrée du contrôleur, toute variation du modèle de vieillissement de la batterie au cours du temps, et d'améliorer ainsi encore la précision du contrôle.

Selon une variante, chaque commande d'équilibrage ou de déséquilibrage des états de charge électrique des accumulateurs électrochimiques ou des modules d'accumulateurs électrochimiques est réalisée via la mise en œuvre d'une méthode de contrôle-commande appartenant au groupe consistant en : une commande par retour d'état ; une commande hiérarchique ; un contrôle Proportionnel, Intégral, Dérivé ; une commande prédictive ; une commande en boucle ouverte ; un apprentissage par renforcement ; une commande tout ou rien et un contrôle optimal.

L'invention concerne également un produit programme d'ordinateur remarquable en ce qu'il comporte un ensemble d'instructions de code de programme pour l'exécution des étapes d'un procédé tel que décrit précédemment, lorsque ledit programme fonctionne sur un ordinateur ou sur un calculateur.

L'invention concerne également un véhicule automobile comprenant un calculateur stockant un produit-programme d'ordinateur tel que décrit précédemment.

On décrira ci-après, à titre d'exemples non limitatifs, des formes d'exécution de la présente invention, en référence aux figures annexées sur lesquelles :
- La figure 1 illustre schématiquement un véhicule selon l'invention, le véhicule étant muni d'un calculateur embarqué. - La figure 2 est un organigramme représentant un procédé d'optimisation de la durée de vie d'une batterie de stockage électrique, mis en œuvre par le calculateur de la figure 1, selon la présente invention.

Les figures 3A à 3C montrent trois diagrammes représentant des courbes fictives de pertes de capacité d'une batterie, selon trois profils distincts.

Par « capacité totale » on entend au sens de la présente invention la capacité d'un accumulateur électrochimique généralement exprimée en Ah lorsque celui-ci est chargé à 100 %. D'un point de vue de chimique, la capacité totale peut être vue comme la quantité de charge électrique maximale (dans le domaine d'utilisation spécifié par le constructeur) qui peut passer entre l'anode et la cathode de l'accumulateur. Cette capacité totale diminue avec le vieillissement de l'accumulateur.

Par « capacité en début de vie » on entend au sens de la présente invention la capacité totale en début de vie d'un accumulateur électrochimique, généralement exprimée en Ah.

Par « perte de capacité » on entend au sens de la présente invention la différence de capacité entre la capacité en début de vie et la capacité totale d'un accumulateur électrochimique, généralement exprimée en Ah.

Par « capacité restante » on entend au sens de la présente invention la quantité de charge électrique qu'un accumulateur électrochimique peut encore fournir, par rapport à sa capacité totale. Cette capacité restante est généralement exprimée en Ah et peut aussi être définie comme la différence entre la capacité initiale et la quantité de charge électrique consommée.

Par « état de santé » on entend au sens de la présente invention un pourcentage qui évolue de 100 % à 0 % et qui permet de caractériser une mesure de la capacité totale d'une batterie électrique par rapport à sa capacité en début de vie. L'état de santé d'une batterie électrique permet de caractériser le niveau de détérioration de la batterie, en tenant compte des coûts de remplacement et de maintenance. Un état de santé de 100 % indique une batterie en pleine santé, tandis que 0 % indique une batterie en très mauvaise santé.

Par « tension de circuit ouvert » on entend au sens de la présente invention une tension électrique d'un accumulateur électrochimique en circuit ouvert, dépendant de l'état de charge, de la température et de l'état de santé de l'accumulateur.

Il faut noter qu'il faut bien distinguer l'état d'énergie (couramment nommé SOE) d'un accumulateur, évoqué dans la présente demande et déjà défini ci-dessus, de l'état de charge d'un accumulateur.

L'état d'énergie correspond à un rapport d'énergie disponible à l'instant courant rapporté à l'énergie totale, sachant que l'énergie est l'intégrale de la puissance. Et l'état de charge (couramment nommé SOC) est un rapport de capacité en A.h disponible à l'instant courant rapporté à la capacité totale, sachant que la capacité est l'intégrale du courant).

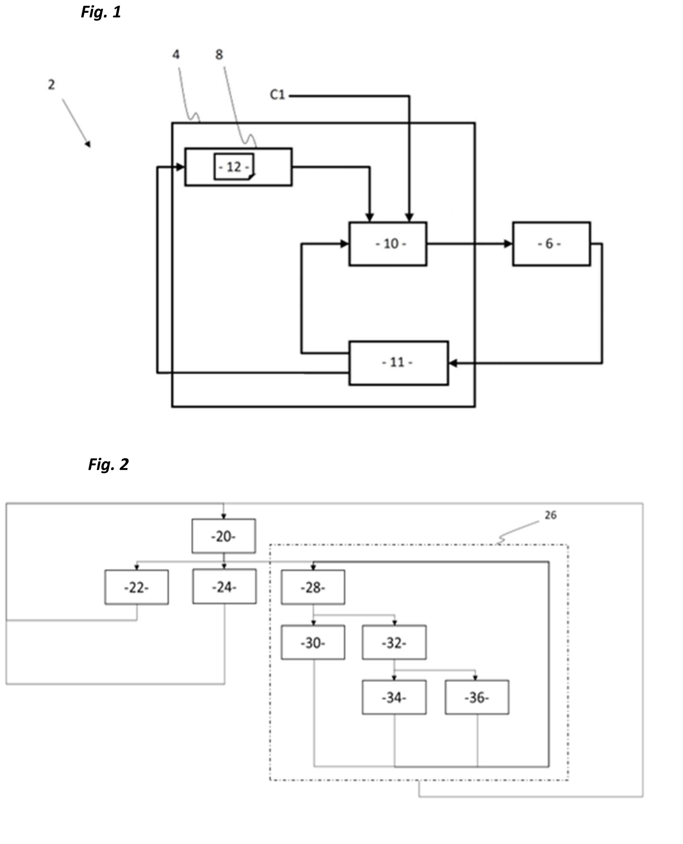

En se référant à la figure 2 la présente invention concerne un procédé, mis en œuvre dans un calculateur 4, d'optimisation de la durée de vie d'une batterie de stockage électrique 6. Selon un mode de réalisation préféré représenté sur la figure 1, le calculateur 4 est embarqué au sein d'un véhicule automobile électrique ou hybride 2, et la batterie de stockage électrique 6 est une batterie du véhicule 2. En variantes non représentées, la batterie de stockage électrique 6 peut également être une batterie stationnaire ou encore une batterie de stockage électrique d'un véhicule électrique non automobile tel que par exemple un poids lourd, un bateau ou encore un avion.

La batterie de stockage électrique 6 est une batterie à équilibrage actif (donc soit une batterie avec transfert de puissance soit une batterie reconfigurable), et est typiquement une batterie de traction du véhicule 2, bien que ce dernier point ne soit pas limitatif dans le cadre de la présente invention. Une telle batterie reconfigurable peut notamment être une batterie à cellules commutées telle que décrite dans la demande de brevet n°WO2013/007810A1**.**

La batterie de stockage électrique 6 comporte de manière classique plusieurs accumulateurs électrochimiques ou plusieurs modules d'accumulateurs électrochimiques connectés en série et/ou en parallèle, ces derniers éléments n'étant pas représentés sur les figures pour des raisons de clarté. Pour une telle batterie à équilibrage actif 6, on fait l'hypothèse (réaliste) que l'énergie dans la batterie 6 est la somme des énergies de chaque accumulateur (à cause de la capacité à rééquilibrer en fin de charge ou décharge de ces derniers).

Le calculateur 4 est relié à la batterie de stockage électrique 6 et comprend des moyens mémoire 8 et un contrôleur 10 relié aux moyens mémoire 8. De préférence, comme illustré sur la figure 1, le calculateur 4 comprend en outre un module d'estimation 11. Le calculateur 4 fait typiquement partie d'un système de gestion de la batterie électrique 6 (un tel système n'étant pas représenté sur les figures pour des raisons de clarté), aussi appelé système BMS (de l'acronyme anglais « Battery Management System »).

Les moyens mémoire 8 stockent un modèle 12 de vieillissement de la batterie de stockage électrique 6. Le modèle de vieillissement 12 incorpore une fonction représentant une perte de capacité de la batterie de stockage électrique 6 en fonction de l'état d'énergie de la batterie 6. Le contrôleur 10 est configuré pour commander l'état de charge électrique de chaque accumulateur électrochimique ou de chaque module d'accumulateurs électrochimiques de la batterie 6. Plus précisément, cette commande prend la forme de l'envoi d'une instruction à l'électronique de puissance de la batterie 6, cette dernière instruction permettant de gérer individuellement (avec différentes contraintes suivant la technologie utilisée) le taux de décharge, de charge ou de transfert d'énergie de chaque accumulateur, ce qui permet d'atteindre des états de charge spécifiques pour chaque accumulateur. Les états de charge électrique des accumulateurs électrochimiques ou des modules d'accumulateurs électrochimiques de la batterie 6 respectent au moins une contrainte d'utilisation C1. Une telle contrainte d'utilisation C1 consiste par exemple en une contrainte prenant en compte la dynamique et la vitesse d'équilibrage de la batterie à équilibrage actif 6, ou en une contrainte prenant en compte les tensions limites des accumulateurs, ou bien en une contrainte prenant en compte le type de batterie à équilibrage actif 6 utilisée, ou encore en une contrainte imposant une quantité d'énergie prédéfinie à la batterie 6. Cette contrainte peut également prendre en compte qu'il ne faut pas trop déséquilibrer la batterie 6 pour garantir à cette dernière d'avoir le temps de rééquilibrer les états de charge des accumulateurs au cas où la batterie 6 s'approche de l'état complètement chargé ou déchargé pour maximiser l'énergie utile stockable.

Le module d'estimation 11 est connecté entre une sortie de la batterie de stockage électrique 6 et une entrée du contrôleur 10, et est configuré pour recevoir au moins une mesure d'un paramètre physique relatif à la batterie 6 et pour estimer, en fonction de la ou chaque mesure, au moins un paramètre relatif à l'état de la batterie 6 (typiquement l'état de charge, l'état d'énergie et/ou l'état de santé de la batterie 6). De préférence, le module d'estimation 11 est configuré en outre pour mettre à jour la fonction représentant la perte de capacité de la batterie 6 en fonction de son état d'énergie, en fonction du ou de chaque paramètre relatif à l'état de la batterie 6 estimé par le module 11.

En référence à la figure 2, il va maintenant être décrit une forme de réalisation du procédé d'optimisation de la durée de vie d'une batterie de stockage électrique 6 selon l'invention, mis en œuvre par un calculateur 4 tel que décrit précédemment.

On suppose qu'initialement les moyens mémoire 8 du calculateur 4 stockent un modèle 12 de vieillissement de la batterie de stockage électrique 6. Le procédé est mis en œuvre pendant une durée divisée en instants d'échantillonnage constants, et comporte des étapes qui sont rebouclées de manière itérative à chaque nouvel instant d'échantillonnage. Chaque instant d'échantillonnage correspond à un état d'énergie de la batterie 6, l'instant d'échantillonnage courant correspondant à l'état d'énergie courant de la batterie 6. Lorsque le module d'estimation 11 est configuré pour mettre à jour la fonction représentant la perte de capacité de la batterie 6 en fonction de son état d'énergie, chaque instant d'échantillonnage correspond en outre à un instant pour lequel la fonction représentant la perte de capacité de la batterie 6 de stockage électrique en fonction de l'état d'énergie de la batterie 6 (cette fonction étant incorporée dans le modèle de vieillissement 12) est mise à jour.

Le procédé comporte une étape initiale 20 au cours de laquelle le calculateur 4 détermine si la fonction représentant la perte de capacité de la batterie de stockage électrique 6 en fonction de l'état d'énergie de la batterie 6 présente ou non une convexité globale stricte ou une concavité globale stricte.

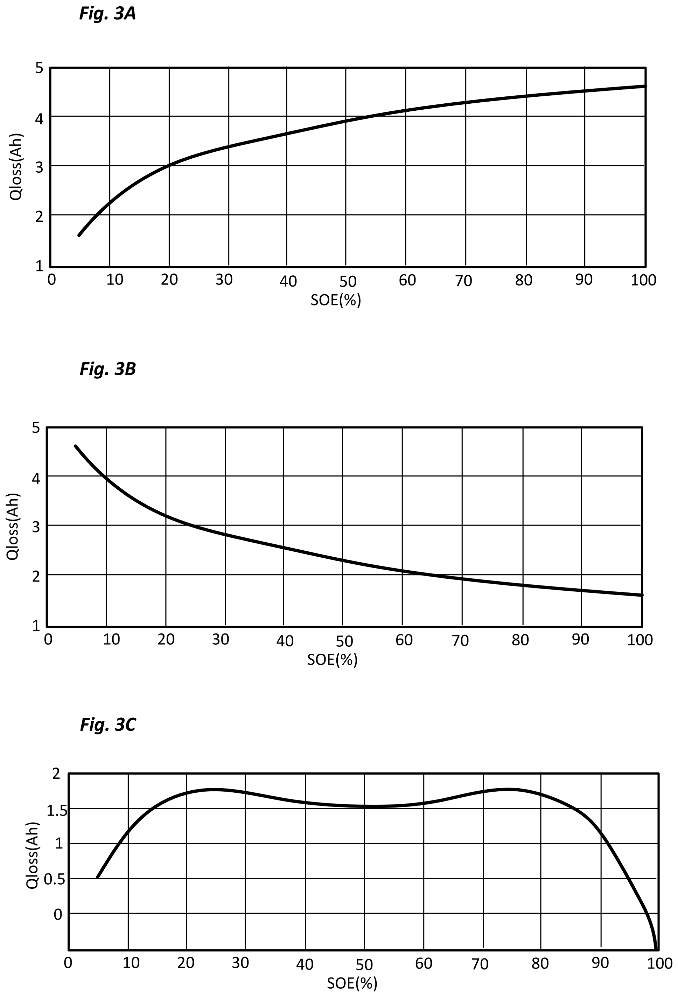

Si cette fonction présente une convexité globale stricte (figure 3A), le procédé comporte une étape suivante 22 au cours de laquelle le calculateur 4 met en œuvre, à chaque instant d'échantillonnage, une commande d'équilibrage des états de charge électrique des accumulateurs électrochimiques ou des modules d'accumulateurs électrochimiques de la batterie 6.

Sinon, si la fonction présente une concavité globale stricte (figure 3B), le procédé comporte une étape suivante 24 au cours de laquelle le calculateur 4 met en œuvre, à chaque instant d'échantillonnage, une commande de déséquilibrage des états de charge électrique des accumulateurs électrochimiques ou des modules d'accumulateurs électrochimiques de la batterie 6.

Sinon, ceci signifie que la fonction représentant la perte de capacité de la batterie de stockage électrique 6 en fonction de l'état d'énergie de la batterie 6 ne présente ni de convexité globale stricte ni de concavité globale stricte (figure 3C). Dans ce cas, au cours d'une étape suivante 26, le calculateur 4 met en œuvre à chaque instant d'échantillonnage les sous-étapes suivantes :
∘ une sous-étape 28 de détermination de si la fonction représentant la perte de capacité de la batterie de stockage électrique 6 en fonction de l'état d'énergie de la batterie 6 présente une convexité ou une concavité locale stricte autour de l'état d'énergie courant de la batterie 6 (cet état d'énergie courant de la batterie 6 correspondant à l'instant d'échantillonnage courant) ;
∘ si cette fonction présente une concavité locale stricte autour de l'état d'énergie courant de la batterie 6, une sous-étape suivante 30 de mise en œuvre d'une commande de déséquilibrage des états de charge électrique des accumulateurs électrochimiques ou des modules d'accumulateurs électrochimiques de la batterie 6 ;
∘ sinon, si la fonction présente une convexité locale stricte autour de l'état d'énergie courant de la batterie 6, une sous-étape suivante 32 de détermination de si une commande d'équilibrage des états de charge électrique des accumulateurs électrochimiques ou des modules d'accumulateurs électrochimiques de la batterie 6 correspond à un minimum global de cette fonction ; puis
   - si une commande d'équilibrage des états de charge électrique des accumulateurs électrochimiques ou des modules d'accumulateurs électrochimiques de la batterie 6 correspond à un minimum global de la fonction, une sous-étape suivante 34 de mise en œuvre d'une commande d'équilibrage des états de charge électrique des accumulateurs électrochimiques ou des modules d'accumulateurs électrochimiques de la batterie 6 ; ou
   - si une commande d'équilibrage des états de charge électrique des accumulateurs électrochimiques ou des modules d'accumulateurs électrochimiques de la batterie 6 ne correspond pas à un minimum global de la fonction, une sous-étape suivante 36 de mise en œuvre d'une commande de déséquilibrage des états de charge électrique des accumulateurs électrochimiques ou des modules d'accumulateurs électrochimiques de la batterie 6.

Il est à noter que, dans ce dernier cas de figure (i.e. si une commande d'équilibrage des états de charge électrique des accumulateurs électrochimiques ou des modules d'accumulateurs électrochimiques de la batterie 6 ne correspond pas à un minimum global de la fonction), la commande de déséquilibrage des états de charge électrique des accumulateurs électrochimiques ou des modules d'accumulateurs électrochimiques de la batterie 6 mise en œuvre au cours de la sous-étape 36 est choisie parmi un ensemble restreint de commandes de déséquilibrage, car tous les déséquilibrages ne sont pas optimums dans ce cas de figure précis.

Dans le cadre de l'invention, on traite des batterie d'une architecture bien particulière, dite batterie reconfigurable, ces batteries permettant une grande flexibilité quant au pilotage individuel de chacune de ses cellules.

De ce fait, il est possible de réaliser un équilibrage actif des cellules, par exemple pour maintenir l'état de charge (SOC) de chaque cellule de la batterie à un niveau identique en permanence. Mais, pour optimiser le vieillissement global, il est également possible de venir jouer sur le niveau d'état de charge de chaque cellule, en faisant en sorte de leur un état de charge adapté, pouvant être différent d'une cellule à l'autre. Il s'agit alors d'une commande de déséquilibrage contrôlé.

Il faut préciser que les cellules d'une batterie disposent principalement de deux types de vieillissement : en calendaire (au repos/stockage) et en cyclage (en fonctionnement avec des cycles de charge/décharge).

Pour un vieillissement très sévère en cyclage à fort état de charge, il peut être judicieux de déséquilibrer l'état de charge des cellules en ne sollicitant qu'une partie des cellules en cyclage alors qu'une autre partie n'est pas utilisée et subit alors un vieillissement de type calendaire. Les cellules utilisées sont amenées le plus vite possible à un point de fonctionnement d'état de charge où le vieillissement en cyclage est le moins prononcé. Autrement dit, comme une batterie n'a souvent jamais besoin de 100% de ses cellules actives en permanence, on les répartir par paquets en fonction de la tension totale demandée par l'application.

De préférence, chaque commande d'équilibrage ou de déséquilibrage des états de charge électrique des accumulateurs électrochimiques ou des modules d'accumulateurs électrochimiques de la batterie 6 est réalisée via la mise en œuvre d'une méthode de contrôle-commande appartenant au groupe consistant en : une commande par retour d'état ; une commande hiérarchique ; un contrôle Proportionnel, Intégral, Dérivé ; une commande prédictive ; une commande en boucle ouverte ; un apprentissage par renforcement ; une commande tout ou rien et un contrôle optimal.

Lorsque le calculateur 4 comprend un module d'estimation 11, comme c'est le cas dans l'exemple illustratif de la figure 1, chaque commande d'équilibrage ou de déséquilibrage des états de charge électrique des accumulateurs électrochimiques ou des modules d'accumulateurs électrochimiques de la batterie 6 est réalisée en tenant compte du ou de paramètre(s) relatif(s) à l'état de la batterie 6 qui est estimé par le module d'estimation 11.

Le procédé peut être réitéré pendant l'utilisation du véhicule, le cas échéant.

Comparativement aux procédés d'optimisation de l'art antérieur, le procédé selon l'invention tient compte du temps d'inutilisation de la batterie 6 et permet d'augmenter la durée de vie de la batterie 6, et ce pour tout type de chimie relative aux accumulateurs électrochimiques de la batterie 6.

Le procédé selon l'invention permet donc un pilotage plus fin et plus précis de l'état de charge des accumulateurs, comparativement aux stratégies de contrôle optimal de l'art antérieur qui visent à l'utilisation d'un groupe d'accumulateurs particulier, ce qui permet d'augmenter substantiellement la durée de vie de la batterie 6.

## Revendications

1. Procédé, mis en œuvre dans un calculateur (4), d'optimisation de la durée de vie d'une batterie de stockage électrique (6), le calculateur (4) étant relié à la batterie de stockage électrique (6), le calculateur (4) comprenant des moyens mémoire (8) stockant un modèle (12) de vieillissement de la batterie de stockage électrique (6), ledit modèle de vieillissement (12) incorporant une fonction représentant une perte de capacité de la batterie de stockage électrique (6) en fonction de l'état d'énergie de la batterie (6), la batterie de stockage électrique (6) étant une batterie à équilibrage actif avec transfert de puissance ou une batterie reconfigurable et comprenant une pluralité d'accumulateurs électrochimiques ou de modules d'accumulateurs électrochimiques connectés en série et/ou en parallèle, le calculateur (4) comprenant en outre un contrôleur (10) configuré pour commander l'état de charge électrique de chaque accumulateur électrochimique ou de chaque module d'accumulateurs électrochimiques de la batterie (6), les états de charge électrique des accumulateurs électrochimiques ou des modules d'accumulateurs électrochimiques respectant au moins une contrainte d'utilisation (C1), ledit procédé étant mis en œuvre pendant une durée divisée en instants d'échantillonnage constants, chaque instant d'échantillonnage correspondant à un état d'énergie de la batterie (6), le procédé étant **caractérisé en ce qu'**il comprend les étapes de :
- détermination initiale (20) de si la fonction représentant la perte de capacité de la batterie de stockage électrique (6) en fonction de l'état d'énergie de la batterie (6) présente ou non une convexité globale stricte ou une concavité globale stricte ;
- si ladite fonction présente une convexité globale stricte, mise en œuvre (22), à chaque instant d'échantillonnage, d'une commande d'équilibrage des états de charge électrique des accumulateurs électrochimiques ou des modules d'accumulateurs électrochimiques ;
- si ladite fonction présente une concavité globale stricte, mise en œuvre (24), à chaque instant d'échantillonnage, d'une commande de déséquilibrage des états de charge électrique des accumulateurs électrochimiques ou des modules d'accumulateurs électrochimiques ;
- si ladite fonction ne présente ni de convexité globale stricte ni de concavité globale stricte, mise en œuvre (26), à chaque instant d'échantillonnage, des étapes suivantes :
∘ détermination (28) de si la fonction représentant la perte de capacité de la batterie de stockage électrique (6) en fonction de l'état d'énergie de la batterie (6) présente une convexité ou une concavité locale stricte autour de l'état d'énergie courant de la batterie (6) ;
∘ si ladite fonction présente une concavité locale stricte autour de l'état d'énergie courant de la batterie (6), mise en œuvre (30) d'une commande de déséquilibrage des états de charge électrique des accumulateurs électrochimiques ou des modules d'accumulateurs électrochimiques ;
∘ si ladite fonction présente une convexité locale stricte autour de l'état d'énergie courant de la batterie (6), détermination (32) de si une commande d'équilibrage des états de charge électrique des accumulateurs électrochimiques ou des modules d'accumulateurs électrochimiques correspond à un minimum global de ladite fonction ;
• si une commande d'équilibrage des états de charge électrique des accumulateurs électrochimiques ou des modules d'accumulateurs électrochimiques correspond à un minimum global de ladite fonction, mise en œuvre (34) d'une commande d'équilibrage des états de charge électrique des accumulateurs électrochimiques ou des modules d'accumulateurs électrochimiques ;
• si une commande d'équilibrage des états de charge électrique des accumulateurs électrochimiques ou des modules d'accumulateurs électrochimiques ne correspond pas à un minimum global de ladite fonction, mise en œuvre (36) d'une commande de déséquilibrage des états de charge électrique des accumulateurs électrochimiques ou des modules d'accumulateurs électrochimiques.

2. Procédé selon la revendication 1, dans lequel le calculateur (4) comprend en outre un module d'estimation (11) connecté entre une sortie de la batterie de stockage électrique (6) et une entrée du contrôleur (10), le module d'estimation (11) étant configuré pour recevoir au moins une mesure d'un paramètre physique relatif à la batterie (6) et pour estimer, en fonction de ladite au moins une mesure, au moins un paramètre relatif à l'état de la batterie (6), et dans lequel chaque commande d'équilibrage ou de déséquilibrage des états de charge électrique des accumulateurs électrochimiques ou des modules d'accumulateurs électrochimiques est réalisée en tenant compte dudit au moins un paramètre relatif à l'état de la batterie (6).

3. Procédé selon la revendication 2, dans lequel le module d'estimation (11) est configuré en outre pour mettre à jour la fonction représentant la perte de capacité de la batterie de stockage électrique (6) en fonction de l'état d'énergie de la batterie (6), en fonction dudit au moins un paramètre relatif à l'état de la batterie (6), chaque instant d'échantillonnage correspondant en outre à un instant pour lequel ladite fonction représentant la perte de capacité de la batterie de stockage électrique (6) en fonction de l'état d'énergie de la batterie (6) est mise à jour.

4. Procédé selon l'une quelconque des revendications 1 à 3, dans lequel chaque commande d'équilibrage ou de déséquilibrage des états de charge électrique des accumulateurs électrochimiques ou des modules d'accumulateurs électrochimiques est réalisée via la mise en œuvre d'une méthode de contrôle-commande appartenant au groupe consistant en : une commande par retour d'état ; une commande hiérarchique ; un contrôle Proportionnel, Intégral, Dérivé ; une commande prédictive ; une commande en boucle ouverte ; un apprentissage par renforcement ; une commande tout ou rien et un contrôle optimal.

5. Produit-programme d'ordinateur comprenant des instructions de code de programme pour l'exécution des étapes d'un procédé selon l'une quelconque des revendications 1 à 4, lorsque ledit programme fonctionne sur un ordinateur ou sur un calculateur (4).

6. Véhicule automobile (2) comprenant un calculateur (4) stockant un produit-programme d'ordinateur selon la revendication 5.
